Europäisches Patentamt

(19) European Patent Office

Office européen des brevets

(11) Publication number: **0 053 014**
**B1**

(12) **EUROPEAN PATENT SPECIFICATION**

(45) Date of publication of patent specification: **03.04.85**

(21) Application number: **81305484.8**

(22) Date of filing: **20.11.81**

(51) Int. Cl.⁴: **H 03 K 5/15**

(54) **Clock generator circuit.**

(30) Priority: **20.11.80 JP 163607/80**

(43) Date of publication of application:
**02.06.82 Bulletin 82/22**

(45) Publication of the grant of the patent:
**03.04.85 Bulletin 85/14**

(84) Designated Contracting States:
**DE FR GB NL**

(56) References cited:
**FR-A-2 064 528**
**FR-A-2 379 198**
**GB-A-2 030 403**
**US-A-3 668 436**
**US-A-3 858 061**
**US-A-3 961 269**
**US-A-4 066 919**
**US-A-4 140 927**

**ELECTRONIC ENGINEERING, vol. 50, no. 616,
December 1978, S.J. CAHILL "A single-chip
two-phase clock", pages 27,29**

(73) Proprietor: **FUJITSU LIMITED**
**1015, Kamikodanaka Nakahara-ku
Kawasaki-shi Kanagawa 211 (JP)**

(72) Inventor: **Ito, Akihiko
3780, Suge Tama-ku
Kawasaki-shi Kanagawa 214 (JP)**
Inventor: **Tanaka, Hisami
1-17-3-301, Utsukushigaoka Midori-ku
Yokohama-shi Kanagawa 227 (JP)**
Inventor: **Takayama, Yoshihisa
616, Futako Takatsu-ku
Kawasaki-shi Kanagawa 213 (JP)**
Inventor: **Kato, Seiji
3-14-15, Chuorinkan
Yamato-shi Kanagawa 242 (JP)**

(74) Representative: **Fane, Christopher Robin King
et al
HASELTINE LAKE & CO. Hazlitt House 28
Southampton Buildings Chancery Lane
London, WC2A 1AT (GB)**

(56) References cited:
  **ELECTRONICS, 20 January 1977, N. HECKT
  "Two-phase clock features nonoverlapping
  outputs", page 99
  Patent Abstracts of Japan, vol. 5, no. 55, 16
  April 1981
  Patent Abstracts of Japan, vol. 2, no. 10, 25
  January 1978, page 10409E77
  IBM TECHNICAL DISCLOSURE BULLETIN, vol.
  20, no. 6, November 1977, F.K. ALLEN
  "Multiphase clocking system with delay
  tracking for control and/or data systems",
  pages 2419 and 2420**

## Description

The present invention relates to a clock generator circuit for generating two pairs of clock signals by using a reference clock signal.

As the case may require, four clock signals, that is, two pairs of clock signals are used. For example, such clock signals are used in a switched capacitor integrator. In this case, it is necessary that a pair of clock signals opposite in sense to each other are not overlapped with another pair of clock signals opposite in sense to each other.

One conventional clock generator circuit comprises a pair of NOR circuits cross-coupled to each other, which serve as an R-S flip-flop. This clock generator circuit generates two non-overlapping clock signals $\phi_1$ and $\phi_2$ opposite in phase to each other. (See: Electronics, page 99, January 20, 1977). In this circuit, when an inverter is connected to the output terminal of each of the NOR circuits, two inverted clock signals $\overline{\phi}_1$ and $\overline{\phi}_2$ of the clock signals $\phi_1$ and $\phi_2$ are also obtained. Thus, the clock generator circuit associated with such inverters generates two pairs of clock signals $\phi_1$ and $\overline{\phi}_1$, and $\phi_2$ and $\overline{\phi}_2$.

However, in the above-mentioned circuit, due to fluctuation in manufacture, the delay time of each of the inverters is fluctuated. At worst, this delay time is so long that the clock signal $\overline{\phi}_1$ may be overlapped with the clock signals $\phi_2$ and $\overline{\phi}_2$ and in addition, the clock signal $\overline{\phi}_2$ may be overlapped with the clock signal $\phi_1$ and $\overline{\phi}_1$.

It is desirable to reduce the likelihood of such overlap occurring.

According to one aspect of the present invention, there is provided a clock generator circuit for generating two pairs of clock signals by using a reference clock signal, comprising: first and second logic circuits, each having first and second input terminals and an output terminal, for generating first and second clock signals, respectively, the first input terminal of each of the first and second logic circuits receiving the reference clock signal; a first delay circuit, connected between the output terminal of the first logic circuit and the second input terminal of the second logic circuit, for delaying and inverting the first clock signal so as to generate a third clock signal; a second delay circuit, connected between the output terminal of the second logic circuit and the second input terminal of the first logic circuit, for delaying and inverting the second clock signal so as to generate a fourth clock signal; the first logic circuit detecting a change of the potential of the fourth clock signal so as to change the potential of the first clock signal, when the potential of the reference clock signal is high, and the second logic circuit detecting a change of the potential of the third clock signal so as to change the potential of the second clock signal, when the potential of the reference clock is low.

According to a second aspect of the present invention, there is provided a clock generator circuit comprising:

first and second logic circuits having respective first inputs to which signals derived from a reference clock generator are applied when the generator circuit is in use;

first output circuitry, defining first and second circuit paths arranged to receive a signal output of the said first logic circuit and leading respectively to first and second output points of the generator circuit, for providing at the said first and second output points respectively first and second clock signals, each of which consists of a series of cyclically repeated clock pulses, the second clock signal being substantially the inverse of the first clock signal but being delayed slightly with respect thereto; and

second output circuitry, defining third and fourth circuit paths arranged to receive a signal output of the said second logic circuit and leading respectively to third and fourth output points of the generator circuit, for providing at the said third and fourth output point respectively third and fourth clock signals, each of which consists of a series of cyclically repeated clock pulses which are shorter in duration than the spaces therebetween and are also shorter in duration than the spaces between the clock pulses of each of the said first and second clock signals, the fourth clock signal being substantially the inverse of the third clock signal but being delayed slightly with respect thereto;

characterised in that the said second output point is connected to a second input of the said second logic circuit which detects a change in the said second clock signal to bring about a change in the said third clock signal when the potential of the reference clock signal is low, and the said fourth output point is connected to a second input of the said first logic circuit which detects a change in the said fourth clock signal to bring about a change in the first said clock signal when the potential of the reference clock signal is high, thereby to prevent the high potential of the third clock signal from overlapping in time with the low potential of the first clock signal and from overlapping in time with the high potential of the second clock signal, and to prevent the low potential of the fourth clock signal from overlapping in time with the low potential of the first clock signal and from overlapping in time with the high potential of the second clock signal.

The present invention will be more clearly understood from the description as set fourth below contrasting the present invention with the conventional circuit and with reference to the accompanying drawings, wherein:

Fig. 1 is a circuit diagram illustrating a general switched capacitor integrator;

Figs. 2A through 2D are timing diagrams showing the signals appearing in the circuit of Fig. 1;

Fig. 3 is a logic circuit diagram illustrating one conventional clock generator circuit;

Figs. 4A through 4F are timing diagrams showing the signals appearing in the circuit of Fig. 3.

Fig. 5 is a logic circuit diagram illustrating an embodiment of the clock generator circuit according to the present invention;

Figs. 6A through 6E are timing diagrams showing the signals appearing in the circuit of Fig. 5;

Fig. 7 is a logic circuit diagram illustrating another embodiment of the clock generator circuit according to the present invention; and

Figs. 8A through 8G are timing diagrams showing the signals appearing in the circuit of Fig. 7.

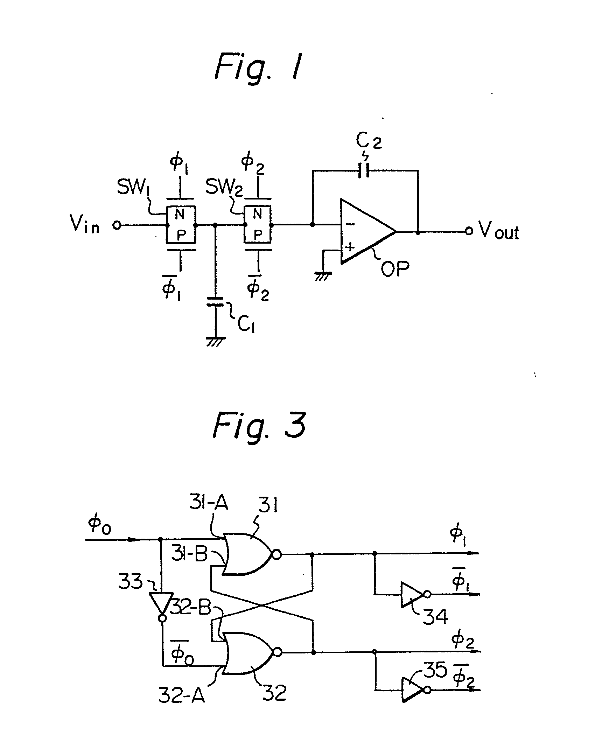

In Fig. 1, which illustrates a general switched capacitor integrator, $SW_1$ and $SW_2$ are switches; $C_1$ and $C_2$ are capacitors; and OP is an operational amplifier. In this case, the capacitor $C_2$ forms a negative feedback path of the operational amplifier OP. When the switch $SW_1$ is turned on, the capacitor $C_1$ is charged by an input voltage $V_{in}$. After that, at the next timing, the switch $SW_1$ is turned off and, in turn, the switch $SW_2$ is turned on. As a result, the charges stored in the capacitor $C_1$ are moved to the capacitor $C_2$. Since the operational amplifier OP operates so as to hold its input terminal (−) at the ground level, an output voltage $V_{out}$ appears in accordance with the quantity of the charges stored in the capacitor $C_1$.

The input voltage $V_{in}$ is sampled by repeating the above-mentioned operation at a frequency of, for example, 128 kHz, so that the output voltage $V_{out}$, corresponding to an integrated value of the sampled voltages, is obtained.

In Fig. 1, each of the switches $SW_1$ and $SW_2$ comprises a CMOS (Complementary MOS) circuit formed by a p-channel type transistor and a n-channel type transistor. Therefore, when the potential of a clock signal $\phi_1$ and the potential of its inverted signal $\overline{\phi}_1$ are high and low, respectively, the siwtch $SW_1$ is turned on, while, when the potential of each of the signals $\phi_1$ and $\overline{\phi}_1$ are low and high, respectively, the switch $SW_1$ is turned off. Similarly, when the potential of a clock signal $\phi_2$ and the potential of its inverted signal $\overline{\phi}_2$ are high and low, respectively, the switch $SW_2$ is turned on, while, when the potential of each of the signals $\phi_2$ and $\overline{\phi}_2$ are low and high, respectively, the switch $SW_2$ is turned off.

It should be noted that the switches $SW_1$ and $SW_2$ should not be simultaneously turned on. If the switches $SW_1$ and $SW_2$ are simultaneously turned on, the capacitor $C_2$ is charged directly by the input voltage $V_{in}$ and as a result, a normal integration operation can not be performed.

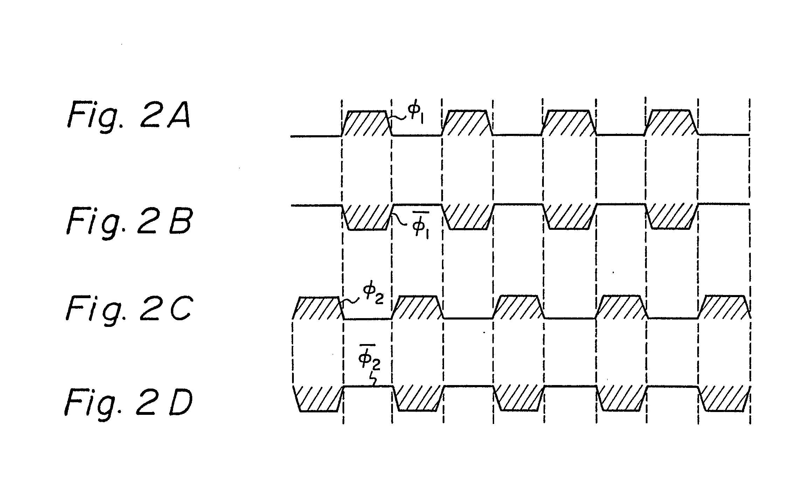

Figs. 2A through 2D are timing diagrams showing the signals appearing in the circuit of Fig. 1. As illustrated in Figs. 2A through 2D, in order to prevent the switches $SW_1$ and $SW_2$ (Fig. 1) from being turned on simultaneously, a pair of the clock signals $\phi_1$ and $\overline{\phi}_1$ are non-overlapped with the other pair of the clock signals $\phi_2$ and $\overline{\phi}_2$. In more detail, the high potential of the clock signal $\phi_1$ R is non-overlapped with the high potential of the clock signal $\phi_2$ and the low potential of the clock signal $\overline{\phi}_2$. In addition, the low potential of the clock signal $\overline{\phi}_1$ is non-

overlapped with the high potential of the clock signal $\phi_2$ and the low potential of the clock signal $\overline{\phi}_2$.

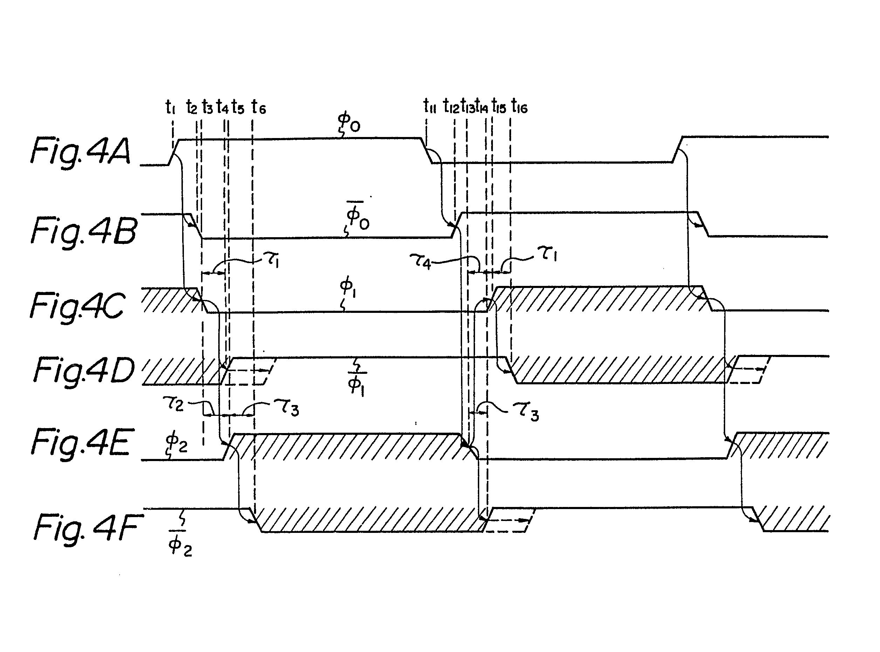

Fig. 3 is a logic circuit diagram illustrating one conventional clock generator circuit. As illustrated in Fig. 3, the clock generator circuit comprises two NOR circuits 31 and 32 cross-coupled to each other which serve as an R-S flip-flop. (See: Electronics, page 99, January 20, 1977). The NOR circuit 31 receives a reference clock signal $\phi_0$ directly, while the NOR circuit 32 receives the reference clock signal $\phi_0$ via an inverter 33. Each of the NOR circuits 31 generates clock signals $\phi_1$ and $\phi_2$, respectively, and in addition, clock signals $\overline{\phi}_1$ and $\overline{\phi}_2$ are obtained by inverting the clock signals $\phi_1$ and $\phi_2$, respectively. For this purpose, two inverters 34 and 35 are provided. Thus, two pairs of clock signals $\phi_1$ and $\overline{\phi}_1$, and $\phi_2$ and $\overline{\phi}_2$ are obtained.

Figs. 4A through 4F are timing diagrams showing the signals in the circuit of Fig. 3. Referring to Figs. 4A through 4F, the operation of the circuit of Fig. 3 will now be explained. At a time $t_1$, the potential of the reference clock signal $\phi_0$ is changed from low to high, as illustrated in Fig. 4A and, in turn, at a time $t_2$, the potential of a signal $\overline{\phi}_0$ is changed from high to low, as illustrated in Fig. 4B. In this state, since the potential at an input terminal 31-B of the NOR circuit 31, which is the same as the potential of the clock signal $\phi_2$ as illustrated in Fig. 4E, remains low, the NOR circuit 31 detects the change of the potential at an input terminal 31-A thereof, so that, at a time $t_3$, the potential of the clock signal $\phi_1$ is changed from high to low, as illustrated in Fig. 4C and, in turn, at a time $t_4$, the potential of the clock signal $\overline{\phi}_1$ is changed from low to high, as illustrated in Fig. 4D. In addition, in this state, since the potential at an input terminal 32-A of the NOR circuit 32, which is the same as the potential of the signal $\overline{\phi}_0$ as illustrated in Fig. 4B, remains low, the NOR circuit 32 detects the change of the potential at an input terminal 32-B thereof, so that, at a time $t_5$, the potential of the clock signal $\phi_2$ is changed from low to high, as illustrated in Fig. 4E and, in turn, at a time $t_6$, the potential of the clock signal $\overline{\phi}_2$ is changed from high to low, as illustrated in Fig. 4F.

As illustrated in Figs. 4C, 4E and 4F, the high potential of the clock signal $\phi_1$ is never overlapped with the high potential (clock pulse) of the clock signal $\phi_2$ and the low potential of the clock signal $\overline{\phi}_2$. Contrary to this, with regard to the clock signal $\overline{\phi}_1$, as illustrated in Figs. 4D, 4E and 4F, if $\tau_1 > \tau_2$ where $\tau_1$ is a delay time of the inverter 34 and $\tau_2$ is a delay time of the NOR circuit 32, the low potential of the clock signal $\overline{\phi}_1$ is overlapped with the high potential of the clock signal $\phi_2$. In addition, if $\tau_1 > \tau_2 + \tau_3$ where $\tau_3$ is a delay time of the inverter 35, the low potential $\overline{\phi}_1$ is also overlapped with the low potential of the clock signal $\overline{\phi}_2$.

Similarly, when the potential of the reference clock signal $\phi_0$ is changed from high to low, as illustrated in Figs. 4C, 4D and 4E, the high potential of the clock signal $\phi_2$ is never overlapped with the high potential of the clock signal $\phi_1$ and the low potential of the clock signal $\overline{\phi}_1$. Contrary to this, with regard to the clock signal $\overline{\phi}_2$, as illustrated in Figs. 4C, 4D and 4F, if $\tau_3 > \tau_4$ where $\tau_4$ is a delay time of the NOR circuit 31, the low potential of the clock signal $\overline{\phi}_2$ is overlapped with the high potential of the clock signal $\phi_1$. In addition, if $\tau_3 > \tau_4 + \tau_1$, the low potential of the clock signal $\overline{\phi}_2$ is overlapped with the low potential (clock pulse) of the clock signal $\overline{\phi}_1$.

However, the delay time $\tau_1$ of the inverter circuit 34 and the delay time $\tau_3$ of the inverter 35 are often fluctuated due to fluctuation in manufacture. Accordingly, it may happens that $\tau_1 > \tau_2$ (or $\tau_2 + \tau_3$) or $\tau_3 > \tau_4$ (or $\tau_4 + \tau_1$) is satisfied. Thus, in the circuit of Fig. 3, the clock signals $\phi_1$ and $\overline{\phi}_1$ may be overlapped with the clock signals $\phi_2$ and $\overline{\phi}_2$.

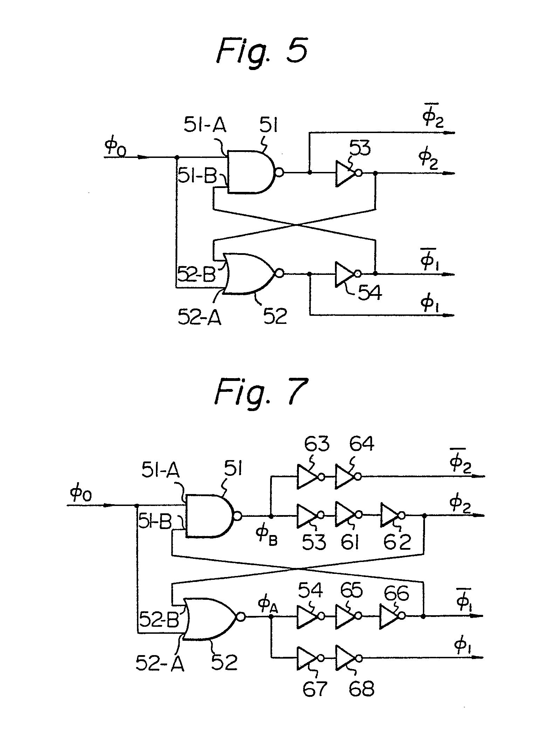

Fig. 5 is a logic circuit diagram illustrating an embodiment of the clock generator circuit according to the present invention. As illustrated in Fig. 5, the clock generator circuit comprises a NAND circuit 51 and a NOR circuit 52 cross-coupled to each other, and two inverters 53 and 54. A reference clock signal $\phi_0$ is supplied commonly to an input terminal 51-A of the NAND circuit 51 and an input terminal 52-A of the NOR circuit 52. The NOR circuit 52 generates a clock signal $\phi_1$ and in turn, the inverter 54 generates a clock signal $\overline{\phi}_1$ which forms a pair with the clock signal $\phi_1$, while the NAND circuit 51 generates a clock signal $\overline{\phi}_2$ and in turn, the inverter 53 generates a clock signal $\phi_2$ which forms a pair with the clock signal $\overline{\phi}_2$. Thus, two pairs of the clock signals $\phi_1$ and $\overline{\phi}_1$, $\phi_2$ and $\overline{\phi}_2$ are obtained.

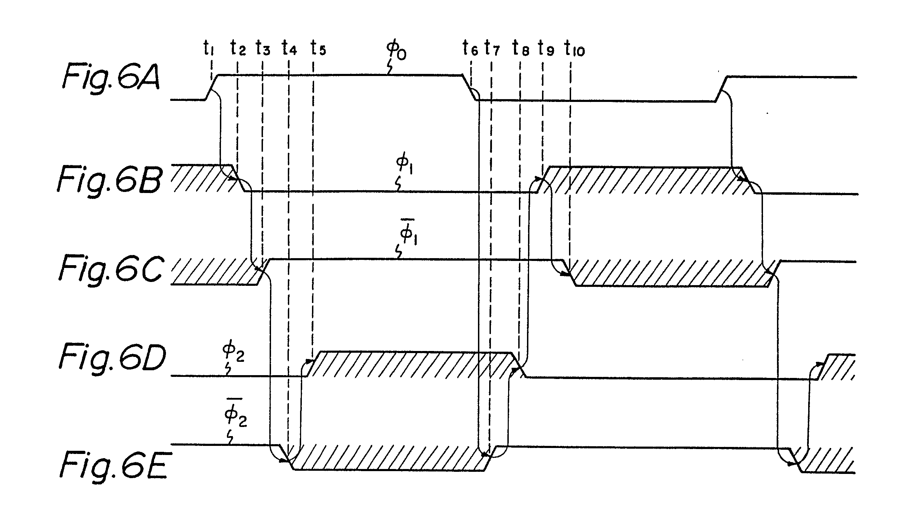

Figs. 6A through 6E are timing diagrams showing the signals appearing in the circuit of Fig. 5. Referring to Figs. 6A through 6E, the operation of the circuit of Fig. 5 will now be explained. At a time $t_1$, the potential of the reference clock signal $\phi_0$ is changed from low to high, as illustrated in Fig. 6A. In this state, since the potential at the input terminal of the NOR circuit 52 remains low, the NOR circuit 52 detects the change of the potential at the input terminal 52-A so that, at a time $t_2$, the potential of the clock signal $\phi_1$ is changed from high to low as illustrated in Fig. 6B and in turn, at a time $t_3$, the potential of the clock signal $\overline{\phi}_1$ is changed from low to high as illustrated in Fig. 6C. In addition, in this state, since the potential at the input terminal 51-A of the NAND circuit 51, which is the same as the potential of the reference clock signal $\phi_0$, remains high as illustrated in Fig. 6A, the NAND circuit 51 detects the change of the potential at the input terminal 51-B so that, at a time $t_4$, the potential of the clock signal $\overline{\phi}_2$ is changed from high to low as illustrated in Fig. 6E and, in turn, the potential of the clock signal $\phi_2$ is changed from low to high as illustrated in Fig. 6D.

As illustrated in Figs. 6B, 6D and 6E, since the rise of the potential of the clock signal $\phi_2$ and the fall of the potential of the clock signal $\overline{\phi}_2$ follow the fall of the potential of the clock signal $\phi_1$, the

high potential of the clock signal $\phi_1$ is never overlapped with the high potential of the clock signal $\phi_2$ and the low potential of the clock signal $\overline{\phi}_2$. In addition, as illustrated in Figs. 6C, 6D and 6E, since the rise of the potential of the clock signal $\phi_2$ and the fall of the potential of the clock signal $\overline{\phi}_2$ follow the rise of the potential of the clock signal $\overline{\phi}_1$, the low potential of the clock signal $\overline{\phi}_1$ is never overlapped with the high potential of the clock signal $\phi_2$ and the low potential of the clock signal $\overline{\phi}_2$.

On the other hand, at a time $t_6$, the potential of the reference clock signal $\phi_0$ falls as illustrated in Fig. 6A and after that, at a time $t_7$, the potential of the clock signal $\overline{\phi}_2$ rises as illustrated in Fig. 6E. And, in turn, at a time $t_8$, the potential of the clock signal $\phi_2$ falls as illustrated in Fig. 6D. After that, at a time $t_9$, the potential of the clock signal $\phi_1$ rises as illustrated in Fig. 6B and, in turn, at a time $t_{10}$, the potential of the clock signal $\overline{\phi}_1$ falls as illustrated in Fig. 6C. Therefore, the high potential of the clock signal $\phi_2$ is never overlapped with the high potential of the clock signal $\phi_1$ and the low potential of the clock signal $\overline{\phi}_1$ and, in addition, the low potential of the clock signal $\overline{\phi}_2$ is never overlapped with the high potential of the clock signal $\phi_1$ and the low potential of the clock signal $\overline{\phi}_1$.

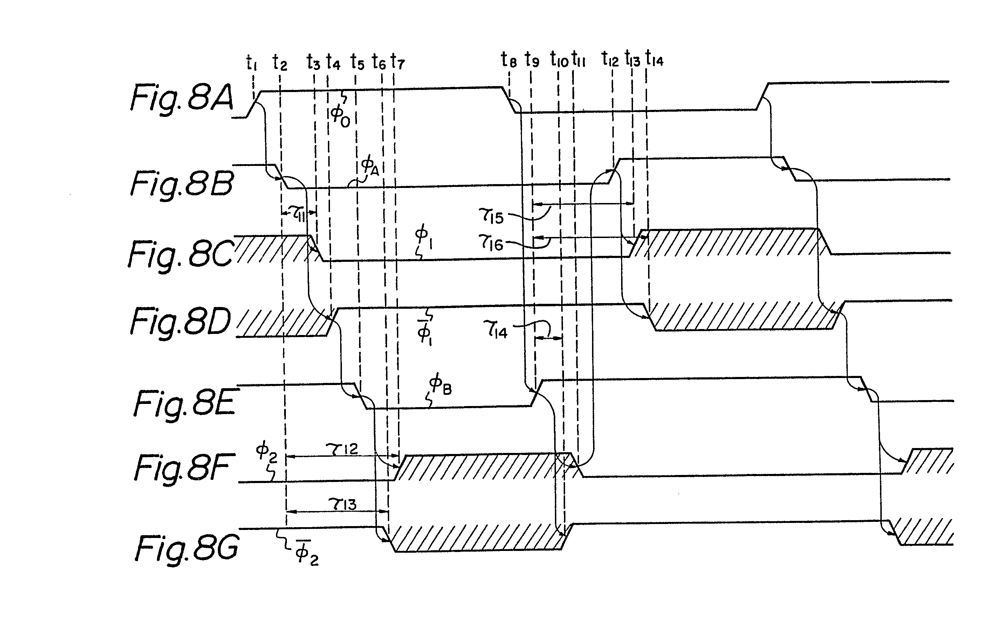

Fig. 7 is a logic circuit diagram illustrating another embodiment of the clock generator clock according to the present invention. In Fig. 7, inverters 61 through 68 are added to Fig. 5. The operation of the circuit of Fig. 7 is similar to that of the circuit of Fig. 5.

Figs. 8A through 8G are timing digrams showing the signals appearing in the circuit of Fig. 7. Referring to Figs. 8A through 8G, the operation of the circuit of Fig. 7 will now be explained. At a time $t_1$, the potential of the reference clock signal $\phi_0$ rises as illustrated in Fig. 8A. After that, at a time $t_2$, the potential of a signal $\phi_A$ generated from the NOR circuit 52 falls, as illustrated in Fig. 8B. As a result, at a time $t_3$, the potential of the clock signal $\phi_1$ falls as illustrated in Fig. 8C and, in turn, at a time $t_4$, the potential of the clock signal $\overline{\phi}_1$ rises as illustrated in Fig. 8D. After the rise of the clock signal $\overline{\phi}_1$, at a time $t_5$, the potential of the signal $\phi_B$ generated from the NAND circuit 51 falls. As a result, at a time $t_6$, the potential of the clock signal $\overline{\phi}_2$ falls as illustrated in Fig. 8G and, in turn, at a time $t_7$, the potential of the clock signal $\phi_2$ rises as illustrated in Fig. 8F.

As illustrated in Figs. 8D, 8F and 8G, since the rise of the potential of the clock signal $\phi_2$ and the fall of the potential of the clock signal $\phi_2$ follow the rise of the potential of the clock signal $\overline{\phi}_1$, the low potential of the clock signal $\overline{\phi}_1$ is never overlapped with the high potential of the clock signal $\phi_2$ and the low potential of the clock signal $\overline{\phi}_2$.

In order to prevent the high potential of the clock signal $\phi_1$ from being overlapped with the high potential of the clock signal $\phi_2$ and the low potential of the clock signal $\overline{\phi}_2$, the following condition should be satisfied:

$$\tau_{11} < \tau_{12} \text{ and } \tau_{11} < \tau_{13} \qquad (1)$$

where $\tau_{11}$ is the total delay timy of the inverters 67 and 68; $\tau_{12}$ is the total delay time of the inverters 54, 65, 66, the NAND circuit 51 and the inverters 53, 61 and 62; and $\tau_{13}$ is the total delay time of the inverters 54, 65, 66, the NAND circuit 51 and the inverters 63 and 64.

On the other hand, at a time $t_8$, the potential of the reference clock signal $\phi_0$ falls as illustrated in Fig. 8A. After that, at a time $t_9$, the potential of the signal $\phi_B$ rises as illustrated in Fig. 8E. As a result, at a time $t_{10}$, the potential of the clock signal $\overline{\phi}_2$ rises as illustrated in Fig. 8G and, in turn, at a time $t_{11}$, the potential of the clock signal $\phi_2$ falls as illustrated in Fig. 8F. After the fall of the potential of the clock signal $\phi_2$, at a time $t_{12}$, the potential of the signal $\phi_A$ rises as illustrated in Fig. 8B. As a result, at a time $t_{13}$, the potential of the clock signal $\phi_1$ rises as illustrated in Fig. 8C and, in turn, at a time $t_{14}$, the potential of the clock signal $\overline{\phi}_1$ falls as illustrated in Fig. 8D.

As illustrated in Figs. 8C, 8D and 8F, since the rise of the potential of the clock signal $\phi_1$ and the fall of the potential of the clock signal $\overline{\phi}_1$ follow the fall of the potential of the clock signal $\overline{\phi}_2$, the high potential of the clock signal $\phi_2$ is never overlapped with the high potential of the clock signal $\phi_1$ and the low potential of the clock signal $\overline{\phi}_1$.

In order to prevent the low potential of the clock signal $\overline{\phi}_2$ from being overlapped with the high potential of the clock signal $\phi_1$ and the low potential of the clock signal $\overline{\phi}_2$, the following condition should be satisfied:

$$\tau_{14} < \tau_{15} \text{ and } \tau_{14} < \tau_{16} \qquad (2)$$

where $\tau_{14}$ is the total delay of the inverters 63 and 64; $\tau_{15}$ is the total dealy time of the inverters 53, 61 and 62, the NOR circuit 52 and the inverters 67 and 68; and $\tau_{16}$ is the total delay time of the inverters 53, 61 and 62, the NOR circuit 52 and the inverters 54, 65 and 66.

Note that the above-mentioned conditions (1) and (2) can be easily attained.

As explained hereinbefore, the clock generator circuit for generating two pairs of clock signals according to the present invention has an advantage in that a pair of clock signals are not overlapped with another pair of clock signals. Therefore, when the clock signals obtained by the clock generator circuit according to the present invention are applied to the switches $SW_1$ and $SW_2$ of the switched capacitor integrator of Fig. 1, the switched capacitor integrator can perform a reliable integration operation.

## Claims

1. A clock generator circuit for generating two pairs of clock signals ($\phi_1$, $\overline{\phi}_1$, $\phi_2$, $\overline{\phi}_2$) by using a reference clock signal ($\phi_0$), comprising:
first and second logic circuits (51, 52), each having first and second input terminals (A, B) and an output terminal, for generating first ($\overline{\phi}_2$) and second ($\phi_1$) clock signals, respectively, the first input terminal of each of said first and second logic circuits receiving said reference clock signal;
a first delay circuit (53), connected between the output terminal of said first logic circuit (51) and the second input terminal (52B) of said second logic circuit, for delaying and inverting said first clock signal ($\overline{\phi}_2$) so as to generate a third clock signal ($\phi_2$);
a second delay circuit (54), connected between the output terminal of said second logic circuit (52) and the second input terminal (51B) of said first logic circuit, for delaying and inverting said second clock signal ($\phi_1$) so as to generate a fourth clock signal ($\overline{\phi}_1$);
said first logic circuit (51) detecting a change of the potential of said fourth clock signal ($\overline{\phi}_1$) so as to change the potential of said first clock signal ($\overline{\phi}_2$), when the potential of said reference clock signal ($\phi_0$) is high; and
said second logic circuit (52) detecting a change of the potential of said third clock signal ($\phi_2$) so as to change the potential of said second clock signal ($\phi_1$), when the potential of said reference clock ($\phi_0$) is low.

2. A clock generator circuit as set forth in claim 1, wherein said first and second logic circuits are a NAND circuit and a NOR circuit, respectively.

3. A clock generator circuit as set forth in claim 1, further comprising:
a third delay circuit (63, 64) connected to the output terminal of said first logic circuit, for delaying said first clock signal;
a fourth delay circuit (67, 68), connected to the output terminal of said second logic circuit, for delaying said second clock signal,
the delay time of said third delay circuit (63, 64) being less than the total delay time of said first delay circuit (53, 61, 62), said second logic circuit (52) and said second delay circuit (54, 65, 66) and being less than the total delay time of said first delay circuit (53, 61, 62), said second logic circuit (52) and said fourth delay circuit (67, 68); and
the delay time of said fourth delay circuit (67, 68) being less than the total delay time of said second delay circuit (54, 65, 66), said first logic circuit (51) and said first delay circuit (53, 61, 62) and being less than the total delay time of said second delay circuit (54, 65, 66), said first logic circuit (51) and said third delay circuit (63, 64).

4. A clock generator circuit comprising:
first and second logic circuits (51, 52) having respective first inputs (51A, 52A) to which signals ($\phi_0$) derived from a reference clock generator are applied when the generator circuit is in use;
first output circuitry, defining first and second circuit paths arranged to receive a signal output of the said first logic circuit and leading respectively to first and second output points of the generator circuit, for providing at the said first and second output points respectively first and second clock signals ($\overline{\phi}_2$, $\phi_2$), each of which consists of a series of cyclically repeated clock pulses, the second clock signal ($\phi_2$) being substantially the inverse of the first clock signal ($\overline{\phi}_2$) but being delayed slightly with respect thereto; and

second output circuitry, defining third and fourth circuit paths arranged to receive a signal output of the said second logic circuit and leading respectively to third and fourth output points of the generator circuit, for providing at the said third and fourth output points respectively third and fourth clock signals ($\phi_1$, $\overline{\phi}_1$), each of which consists of a series of cyclically repeated clock pulses which are shorter in duration than the spaces therebetween and are also shorter in duration than the spaces between the clock pulses of each of the said first and second clock signals ($\overline{\phi}_2$, $\phi_2$), the fourth clock signal ($\overline{\phi}_1$) being substantially the inverse of the third clock signal ($\phi_1$) but being delayed slightly with respect thereto;

characterised in that the said second output point is connected to a second input (52B) of the said second logic circuit which detects a change in the said second clock signal ($\phi_2$) to bring about a change in the said third clock signal ($\phi_1$) when the potential of the reference clock signal ($\phi_0$) is low, and the said fourth output point is connected to a second input (51B) of the said first logic circuit which detects a change in the said fourth clock signal ($\overline{\phi}_1$) to bring about a change in the said first clock signal ($\overline{\phi}_2$) when the potential of the reference clock signal ($\phi_0$) is high, thereby to prevent the high potential of the third clock signal ($\phi_1$) from overlapping in time with the low potential of the first clock signal ($\overline{\phi}_2$) and from overlapping in time with the high potential of the second clock signal ($\phi_2$), and to prevent the low potential of the fourth clock signal ($\overline{\phi}_1$) from overlapping in time with the low potential of the first clock signal ($\overline{\phi}_2$) and from overlapping in time with the high potential of the second clock signal ($\phi_2$).

5. A clock generator circuit as claimed in claim 4, wherein the said fourth clock signal ($\overline{\phi}_1$) is similar to but substantially 180 degrees out of phase with one of the said first and second clock signals.

6. A clock generator circuit as claimed in claim 4, wherein the said fourth clock signal ($\overline{\phi}_1$) is similar to but substantially 180 degrees out of phase with the said first clock signal ($\overline{\phi}_2$).

**Patentansprüche**

1. Taktgeberschaltung zur Erzeugung von zwei Paaren von Taktsignalen ($\phi_1$, $\overline{\phi}_1$, $\phi_2$, $\overline{\phi}_2$) unter Verwendung eines Referenztaktsignals ($\phi_0$), gekennzeichnet durch:

erste und zweite Logikschaltungen (51, 52), die jeweils einen ersten und einen zweiten Eingangsanschluß (A, B) und einen Ausgangsanschluß aufweisen und zur Erzeugung erster ($\overline{\phi}_2$) bzw. zweiter ($\phi_1$) Taktsignale dienen und von denen der erste Eingangsanschluß jeweils das genannte Referenztaktsignal empfängt;

eine erste Verzögerungsschaltung (53), die, zur Verzögerung und Invertierung des genannten

ersten Taktsignals ($\overline{\phi}_2$), zwischen den Ausgangsanschluß der genannten ersten Logikschaltung (51) und den zweiten Eingangsanschluß (52B) der genannten zweiten Logikschaltung geschaltet ist, um so ein drittes Taktsignal ($\phi_2$) zu erzeugen;

eine zweiten Verzögerungsschaltung (54), die, zur Verzögerung und Invertierung des genannten zweiten Taktsignals ($\phi_1$), zwischen den Ausgangsanschluß der zweiten Logikschaltung (52) und den zweiten Eingangsanschluß (51B) der genannten ersten Logikschaltung geschaltet ist, um so ein viertes Taktsignal ($\overline{\phi}_1$) zu erzeugen;

und dadurch, daß die erste Logikschaltung (51) einen Potentialwechsel des vierten Taktsignale ($\overline{\phi}_1$) feststellt, um so das Potential des ersten Taktsignals ($\overline{\phi}_2$) zu ändern, wenn das Potential des genannten Referenztaktsignals ($\phi_0$) hoch ist; und

die genannte zweite Logikschaltung (52) einen Wechsel des Potentials des genannten dritten Taktsignals ($\phi_2$) feststellt, um so das Potential des genannten zweiten Taktsignals ($\phi_1$) zu ändern, wenn das Potential des genannten Referenztaktsignals ($\phi_0$) niedrig ist.

2. Taktgeberschaltung nach Anspruch 1, bei der die genannten erste und zweite Logikschaltung ein NAND-Glied bzw. ein NOR-Glied ist.

3. Taktgeberschaltung nach Anspruch 1, ferner dadurch gekennzeichnet:

daß eine dritte Verzögerungsschaltung (63, 64) mit dem Ausgangsanschluß der genannten ersten Logikschaltung verbunden ist, um das genannte erste Taktsignal zu verzögern;

eine vierte Verzögerungsschaltung (67, 68) mit dem Ausgangsanschluß der genannten zweiten Logikschaltung verbunden ist, um das genannte zweite Taktsignal zu verzögern.

die Verzögerungszeit der genannten dritten Verzögerungsschaltung (63, 64) kleiner als die gesamte Verzögerungszeit der genannten ersten Verzögerungsschaltung (53, 61, 62), der genannten zweiten Logikschaltung (52) und der genannten zweiten Verzögerungsschaltung (54, 65, 66) und geringer als die gesamte Verzögerungszeit der genannten ersten Verzögerungsschaltung (53, 61, 62) der genannten zweiten Logikschaltung (52) und der genannten vierten Verzögerungsschaltung (67, 68) ist; und

die Verzögerungszeit der genannten vierten Verzögerungsschaltung (67, 68) geringer als die gesamte Verzögerungszeit der genannten zweiten Verzögerungsschaltung (54, 65, 66), der genannten ersten Logikschaltung (51) und der genannten ersten Verzögerungsschaltung (53, 61, 62) und geringer als die gesamte Verzögerungszeit der genannten zweiten Verzögerungsschaltung (54, 65, 66), der genannten ersten Logikschaltung (51) und der genannten dritten Verzögerungsschaltung (63, 64) ist.

4. Taktgeberschaltung mit:

ersten und zweiten Logikschaltungen (51, 52), welche jeweils erste Eingänge (51A, 52A) haben, denen Signale ($\phi_0$), die von einem Referenztaktgeber abgeleitet sind, zugeführt werden, wenn die Taktgeberschaltung in Betrieb ist;

einer ersten Ausgangsschaltung, welche erste und zweite Wege definiert, die zum Empfang eines Signalausgangs der genannten ersten Logikschaltung dienen und zum ersten bzw. zweiten Ausgnagspunkt der Taktgeberschaltung führen, um an dem ersten bzw. zweiten Ausgangspunkt erste bzw. zweite Taktsignale ($\overline{\phi}_2$, $\phi_2$) zu liefern. von denen jedes aus einer Reihe von zyklisch wiederholten Taktimpulsen besteht, und das zweite Taktsignal ($\phi_2$) das Inverse des ersten Taktsignals ($\overline{\phi}_2$), gegenüber diesem jedoch etwas verzögert ist; und

einer zweiten Ausgangsschaltung, die dritte und vierte Wege definiert, welche zum Empfang eines Signalausgangs von der zweiten Logikschaltung ausgelegt sind und zu dem dritten bzw. vierten Ausgangspunkt der Taktgeberschaltung führen, um an dem dritten bzw. vierten Ausgangspunkt dritte und vierte Taktsignale ($\phi_1$, $\overline{\phi}_1$) zu erzeugen, von denen jedes aus einer Reihe von zyklisch wiederholten Taktimpulsen besteht, deren Dauer kürzer als die Abstände zwischen ihnen und auch kürzer als die Abstände zwischen den Taktimpulsen von jedem der genannten ersten und zweiten Taktsignale ($\overline{\phi}_2$, $\phi_2$) sind, und das vierte Taktsignal ($\overline{\phi}_1$) im wesentlichen das Inverse des dritten Taktsignals ($\phi_1$), gegenüber diesem jedoch geringfügig verzögert ist;

dadurch gekennzeichnet, daß der genannte zweite Ausgangspunkt mit einem zweiten Eingang (52B) der genannten zweiten Logikschaltung verbunden ist, welche einen Wechsel des genannten zweiten Taktsignals ($\phi_2$) feststellt, um einen Wechsel in dem genannten dritten Taktsignal ($\phi_1$) herbeizuführen, wenn das Potential des Referenztaksignals ($\phi_0$) niedrig ist, und der genannte vierte Ausgangspunkt mit einem zweiten Eingang (51B) der genannten ersten Logikschaltung verbunden ist, welche einen Wechsel in dem vierten Taktsignal ($\overline{\phi}_1$) festellt, um einen Wechsel in dem genannten ersten Taktsignal ($\overline{\phi}_2$) herbeizuführen, wenn das Potential des Referenztaksignals ($\phi_0$) hoch ist, um dadurch zu verhindern, daß das hohe Potential des dritten Taktsignals ($\phi_1$) zeitlich mit dem niedrigen Potential des ersten Taktsignals ($\overline{\phi}_2$) überlappt und zeitlich mit dem hohen Potential des zweiten Taktsignals ($\phi_2$) überlappt, und um zu verhindern, daß das niedrige Potential des vierten Taktsignals ($\overline{\phi}_1$) zeitlich mit dem niedrigen Potential des ersten Taktsignals ($\overline{\phi}_2$) und zeitlich mit dem hohen Potential des zweiten Taktsignals ($\phi_2$) überlappt.

5. Taktgeberschaltung nach Anspruch 4, dadurch gekennzeichnet, daß das genannte vierte Taktsignal ($\overline{\phi}_1$) entweder dem ersten oder dem zweiten Taktsignal ähnlich, jedoch gegenüber diesen im wesentlichen um 180 Grad phasenversetzt ist.

6. Taktgeberschaltung nach Anspruch 4, bei welcher das genannte vierte Taktsignal ($\overline{\phi}_1$) dem genannten ersten Taktsignal ($\overline{\phi}_2$) ähnlich, jedoch gegenüber diesem in wesentlichen um 180 Grad phasenversetzt ist.

**Revendications**

1. Circuit de générateur de signaux d'horloge pour générer deux paires de signaux d'horloge ($\phi_1$, $\overline{\phi}_1$, $\phi_2$, $\overline{\phi}_2$) à l'aide d'un signal d'horloge de référence ($\phi_0$), comportant:

un premier et second circuit logique (51, 52), chacun comprenant une première et une seconde borne d'entrée (A, B) et une borne de sortie, pour générer le premier signal d'horloge ($\overline{\phi}_2$) et le second signal d'horloge ($\phi_1$) respectivement, la première borne d'entrée de chacun desdits premier et second circuits logiques recevant ledit signal d'horloge de référence;

un premier circuit à retard (53), connecté entre la borne de sortie dudit premier circuit logique (51) et la seconde borne d'entrée (52B) dudit second circuit logique, pour retarder et prendre l'opposé dudit premier signal d'horloge ($\overline{\phi}_2$) de façon à générer un troisième signal d'horloge ($\phi_2$);

un second circuit à retard (54), connecté entre la borne de sortie dudit second circuit logique (52) et la seconde borne d'entrée (51B) dudit premier circuit logique, pour retarder et prendre l'opposé dudit second signal d'horloge ($\phi_1$), de façon à générer un quatrième signal d'horloge ($\overline{\phi}_1$);

ledit premier circuit logique (51) détectant un changement du potentiel dudit quatrième signal d'horloge ($\overline{\phi}_1$) de façon à changer le potentiel dudit premier signal d'horloge ($\overline{\phi}_2$) lorsque le potentiel dudit signal d'horloge de référence ($\phi_0$) est haut; et

ledit second circuit logique (52) détectant un changement du potentiel dudit troisième signal d'horloge ($\phi_2$) de façon à changer le potentiel dudit second signal d'horloge ($\phi_1$) lorsque le potentiel dudit signal d'horloge de référence ($\phi_0$) est bas.

2. Circuit de générateur de signaux d'horloge comme énoncé par la revendication 1, caractérisé en ce que lesdits premier et second circuits logiques sont un circuit NON ET et un circuit NON OU, respectivement.

3. Circuit de générateur d'horloge comme énoncé dans la revendication 1, comportant en outre:

un troisème circuit à retard (63, 64) connecté à la bande de sortie dudit premier circuit logique, pour retarder ledit premier signal d'horloge;

un quatrième circuit à retard (67, 68), connecté à la bande de sortie dudit second circuit logique, pour retarder ledit second signal d'horloge,

le temps de retard dudit troisième circuit à retard (63, 64) étant inférieur au temps de retard total dudit premier circuit à retard (53, 61, 62), dudit second circuit loqique (52) et dudit second circuit à retard (54, 65, 66), et étant inférieur au temps de retrad total dudit premier circuit à retard (53, 61, 62), dudit second circuit logique (52) et dudit quatrième circuit à retard (67, 68); et

le temps de retard dudit quatrième circuit à retard (67, 68) étant inférieur au temps de retard total dudit second circuit à retard (54, 65, 66), dudit premier circuit logique (51), et dudit premier circuit à retard (53, 61, 62) et étant inférieur au temps de retard total dudit second circuit à retard (54, 65, 66), dudit premier circuit logique (51) et dudit troisième circuit à retard (63, 64).

4. Circuit de générateur de signaux d'horloge comportant:

un premier et un second circuits logiques (51, 52) présentant respectivement une première entrée (51A, 52A) auxquelles des signaux ($\phi_0$) dérivés d'un générateur de signaux d'horloge de référence sont appliqués lorsque le circuit de générateur est en usage;

un premier circuit de sortie, définissant un premier et un second trajets de circuit disposés pour recevoir un signal de sortie dudit premier circuit logique et conduisant respectivement au premier et au second points de sortie du circuit de générateur, pour fournir audit premier point de sortie et audit second point de sortie, respectivement, un premier signal d'horloge et un second signal d'horloge ($\overline{\phi}_2$, $\phi_2$), chacun d'eux constitué d'une série d'impulsions d'horloge répétées cycliquement, le second signal d'horloge ($\phi_2$) étant réellement l'opposé du premier signal d'horloge ($\overline{\phi}_2$), mais étant retardé légèrement par rapport à lui; et

un second circuit de sortie, définissant le troisième et le quatrième trajets de circuit disposés pour recevoir un signal de sortie dudit second circuit logique et conduisant respectivement au troisième et au quatrième points de sortie du générateur de circuit, pour fournir audit troisième point de sortie et audit quatrième point de sortie, respectivement, un troisième signal d'horloge et un quatrième signal d'horloge ($\phi_1$, $\overline{\phi}_1$), chacun d'eux constitué d'une série d'impulsions d'horloge répétées cycliquement d'une durée plus courte que les intervalles entre elles et également d'une durée plus courte que les intervalles entre les impulsions d'horloge de chacun desdits premier et second signaux d'horloge ($\overline{\phi}_2$, $\phi_2$), le quatrième signal d'horloge ($\overline{\phi}_1$) étant réellement l'opposé du troisième d'horloge ($\phi_1$) mais étant retardé légèrement par rapport à lui;

caractérisé en ce que ledit second point de sortie est connecté à une seconde entrée (52B) dudit second circuit logique qui détecte un changement dans ledit second signal d'horloge ($\phi_2$) pour amener un changement dans ledit troisième signal d'horloge ($\phi_1$) lorsque le potentiel du signal d'horloge de référence ($\phi_0$) est bas; et en ce que ledit quatrième point de sortie est connecté à une seconde entrée (51B) dudit premier circuit logique qui détecte un changement dans ledit quatrième signal d'horloge ($\overline{\phi}_1$) pour amener un changement dans ledit premier signal d'horloge ($\overline{\phi}_2$) lorsque le potentiel du signal d'horloge de référence ($\phi_0$) est haut, interdisant par là que le potentiel haut du troisième signal d'horloge ($\phi_1$) ne se recouvre dans le temps avec le potentiel bas du premier signal d'horloge ($\overline{\phi}_2$) et ne se recouvre dans le temps avec le potentiel haut du second signal d'horloge ($\phi_2$) et pour éviter que le potentiel bas du quatrième signal d'horloge ($\overline{\phi}_1$) ne se recouvre dans le temps avec le potentiel bas du premier signal d'horloge ($\overline{\phi}_2$) et ne se recouvre dans le temps avec le potentiel haut du second signal d'horloge $\phi_2$)

5. Circuit de générateur de signaux d'horloge comme revendiqué dans la revendication 4, caractérisé en ce que ledit quatrième signal d'horloge ($\overline{\phi}_1$) est semblable à l'un dudit premier signal d'horloge et dudit second signal d'horloge, mais réellement déphasé de 180° par rapport à lui.

6. Circuit de générateur de signaux d'horloge comme revendiqué dans la revendication 4, caractérisé en ce que ledit quatrième signal d'horloge ($\overline{\phi}_1$) est semblable audit premier signal d'horloge ($\overline{\phi}_2$) mais réellement déphasé de 180° par rapport à lui.

# Fig. 1

# Fig. 3

1

Fig. 2A

Fig. 2B

Fig. 2C

Fig. 2D

Fig.4A

Fig.4B

Fig.4C

Fig.4D

Fig.4E

Fig.4F

## Fig. 5

## Fig. 7

Fig.6A

Fig.6B

Fig.6C

Fig.6D

Fig.6E

$t_1$ $t_2$ $t_3$ $t_4$ $t_5$     $\phi_0$     $t_6$ $t_7$ $t_8$ $t_9$ $t_{10}$

$\phi_1$

$\overline{\phi}_1$

$\phi_2$

$\overline{\phi}_2$

0 053 014

0 053 014